# EUROPEAN PATENT SPECIFICATION

(11) **EP 2 764 796 B1**
(45) Date of publication and mention of the grant of the patent: **07.01.2015**
(21) Application number: 13154507.1
(22) Date of filing: 08.02.2013
(51) Int. Cl.: A47B 88/04, H05K 7/14

(54) **Slide rail assembly and rack system**
Gleitschienenanordnung und Regalsystem
Ensemble de rail coulissant et système de rayonnage

(43) Date of publication of application: 13.08.2014
(73) Proprietor: King Slide Works Co., Ltd., Kaohsiung City (TW); King Slide Technology Co., Ltd., Kaohsiung City (TW)
(72) Inventor: Chen, Ken-Ching, Kaohsiung City (TW); Yang, Shun-Ho, Kaohsiung City (TW); Wang, Chun-Chiang, Kaohsiung City (TW)
(74) Representative: Viering, Jentschura & Partner Patent- und Rechtsanwälte

(56) References cited:
- WO-A1-99/42020
- DE-C1- 19 710 023
- DE-U1-202009 011 027
- US-A- 5 470 143
- US-A1- 2001 040 142
- US-A1- 2009 283 652
- US-A1- 2011 148 264

## Description

The present invention relates to a slide rail assembly and a rack system and more particularly, to a slide rail assembly, having a reinforcement member, whose supports are adjustable to meet requirements of maximum or minimum and to reinforce the structural strength thereof.

### BACKGROUND OF THE INVENTION

U.S. Patent No. 8,028,965 to CHEN discloses a slide assembly with an adjustable bracket which can be installed to different depths of the racks. The amount of the adjustment of the bracket is made by the relative displacement between the cover (30) and the rear support (50). When the rear support is completely retracted to the cover, the total length of the bracket reaches its minimum length. When the rear support is pulled, relative to the cover, to its extreme position, the total length of the bracket reaches its maximum length. However, when the rear support is pulled to its extreme position, the rear support must be partially inserted into the cover so as to maintain the support strength. Accordingly, the length that the rear support inserted in the cover cannot be too short. If the total length of the bracket is to be increased, the length that the rear support is pulled relative to the cover cannot be overly increased so as to maintain a minimum support strength. Consequently, to increase the total length of the bracket, only the two respective lengths of the cover or the rear support can be increased. However, once the length of one of the cover or the rear support is increased, the minimum length of the bracket is increased and cannot meet the original requirement of the minimum length of the support.

The present invention intends to provide a slide rail assembly with a reinforcement member which is adjustable to meet requirements of maximum or minimum and to reinforce the structural strength thereof.

### SUMMARY OF THE INVENTION

The present invention relates to a slide rail assembly according to claim 1.

Preferably, an engaging hole is defined in the rear end of the bridge wall of the outer rail. The body of the reinforcement member has a slot and a contact portion which extends from the body and is inserted into the slot. The contact portion has a protrusion which is engaged with the engaging hole of the outer rail.

Preferably, the second side portion of the second rear support has a side hole and an extension plate extends from the second side portion and is inserted into the side hole. The body of the reinforcement member has a stop which contacts the extension plate of the second rear support.

Preferably, each of the first support parts of the reinforcement member comprises a first support plate and a first bent section. The first support plate substantially extends perpendicularly from the body of the reinforcement and is located on the rear side of the body. The first bent section is bent from the first support plate.

Preferably, each of the at least two second support parts of the reinforcement member comprises a second support plate and a second bent section. The second support plate substantially extends perpendicularly from the body of the reinforcement and is located on the front side of the body. The second bent section is bent from the second support plate.

One aspect of the present invention is to provide a slide rail assembly wherein the length of the slide rail relative to the depth of the rack can be adjusted so that the slide rail assembly is installed to the rack and has reinforced connection.

The present invention will become more obvious from the following description when taken in connection with the accompanying drawings which show, for purposes of illustration only, a preferred embodiment in accordance with the present invention defined by the appended claims.

### BRIEF DESCRIPTION OF THE DRAWINGS

Fig. 1 is an exploded view to show the slide rail assembly of the present invention;
Fig. 2 shows another angle of view of the reinforcement member of the slide rail assembly of the present invention;
Fig. 3 shows that the reinforcement member is mounted to the outer rail;
Fig. 4 shows that the slide rail assembly is installed to a rack and the reinforcement member is connected to the rear end of the outer rail;
Fig. 5 shows that the slide rail assembly is installed to a rack and the reinforcement member is adjusted to move a distance, and
Fig. 6 shows that the slide rail assembly is installed to a rack and the reinforcement member is in contact with the first rear support.

### DETAILED DESCRIPTION OF THE PREFERRED EMBODIMENT

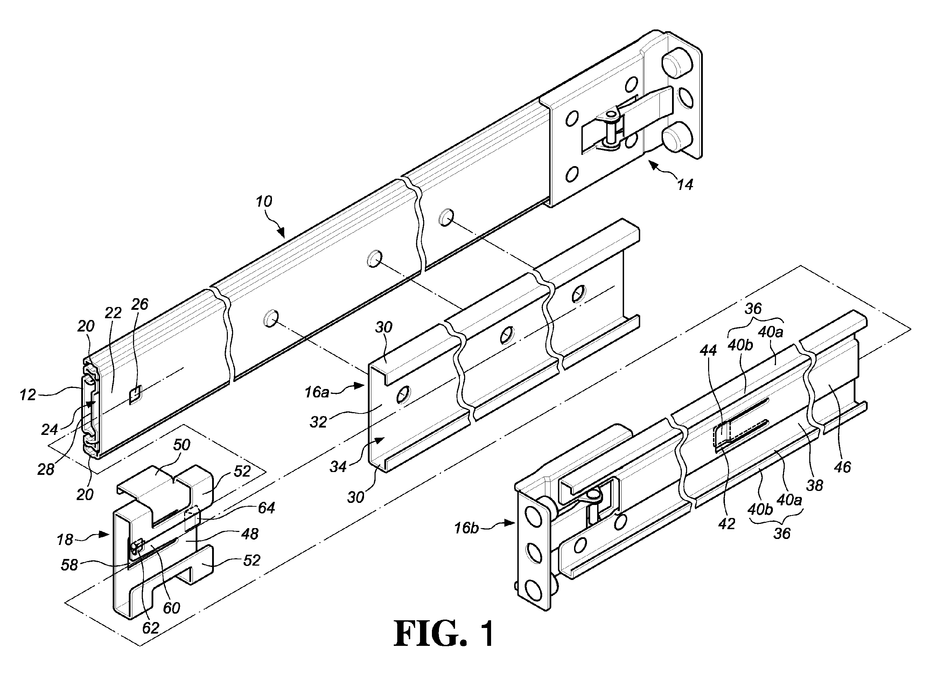

Referring to Fig. 1, the slide rail assembly of the present invention comprises an outer rail 10, an inner rail 12, a front support 14, a first rear support 16a, a second rear support 16b and a reinforcement member 18.

The outer rail 10 has a longitudinal length and two side walls 20 are connected two sides of the outer rail 10. A bridge wall 22 is connected between the two side walls 20. A longitudinal path 24 is defined between the two side walls 20 and the bridge wall 22. Preferably, an engaging hole 26 is defined through the rear end of bridge wall 22.

The inner rail 12 is slidably connected to the longitudinal path 24 of the outer rail 10. Preferably, an intermediate rail 28 is slidably connected between the inner rail 12 and the outer rail 10, so that the inner rail 12 is able to be extended to a longer distance relative to the outer rail 10 by the intermediate rail 28.

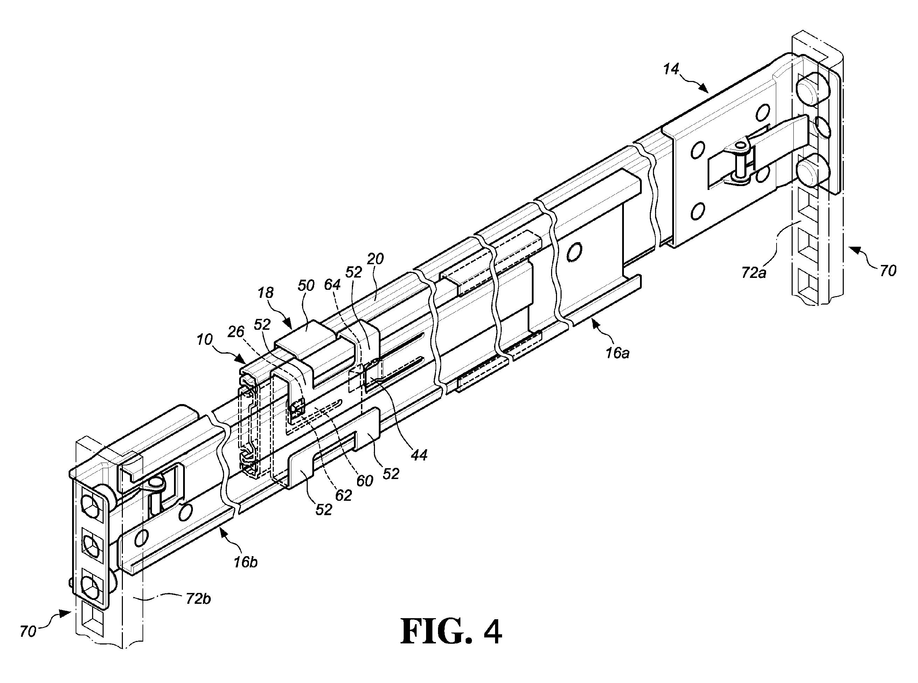

The front support 14 is connected to the front end of the outer rail 10 and secured to the bridge wall 22. The front support 14 can be installed to a front post 72a (as shown in Fig. 4) on front end of a rack in practical use.

The first rear support 16a is installed to the outside of the bridge wall 22 of the outer rail 10 and comprises two first support portions 30 and a first side portion 32 which is connected between the two first support portions 30. Preferably, the first rear support 16a is fixedly installed to the bridge wall 22. A first path 34 is defined between the insides of the two first support portions 30 and the first side portion 32.

The second rear support 16b is movably installed to the first rear support 16a. Preferably, the second rear support 16b is movably located in the first path 34 of the first rear support 16a. The second rear support 16b has two second support portions 36 and a second side portion 38 which is connected between the two second support portions 36. Each of the two second support portions 36 has a first support section 40a and a second support section 40b. The first support section 40a substantially extends perpendicularly from the second side portion 38. The second support section 40b substantially extends perpendicularly from the first support section 40a. The second side portion 38 of the second rear support 16b has a side hole 42 and an extension plate 44 which extends from the second side portion 38 and is inserted into the side hole 42. Preferably, a central section 46 protrudes from the second side portion 38 of the second rear support 16b and extends along the lengthwise direction of the second side portion 38 so as to reinforce the strength of the second rear support 16b. In practical use, the second rear support 16b can be installed to the rear post 72b (as show in Fig. 4) on the rear end of the rack.

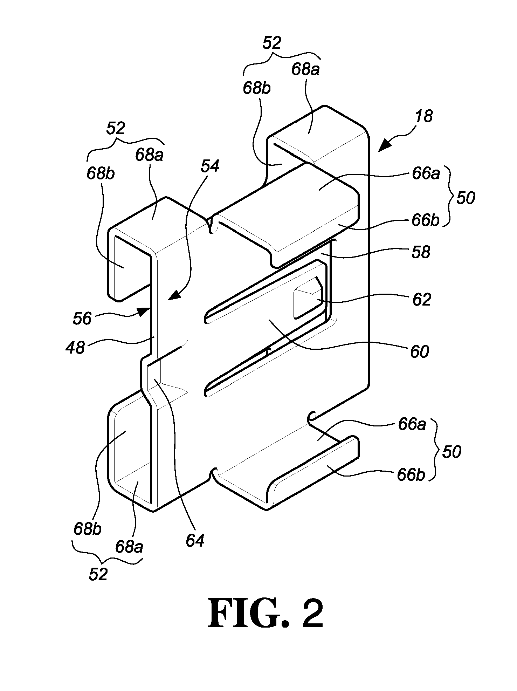

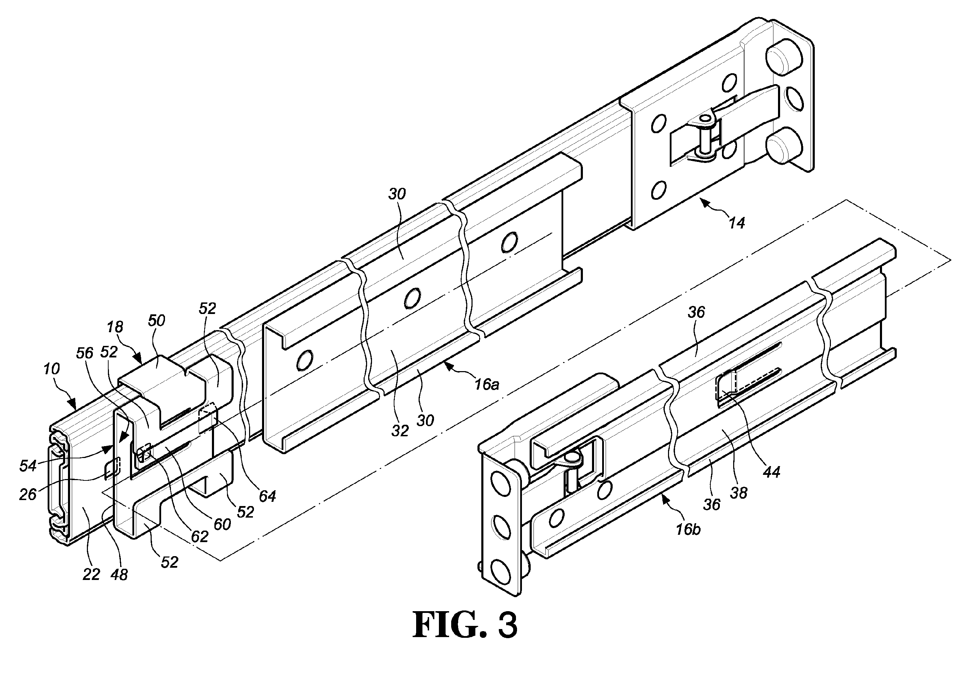

As shown in Fig. 2, the reinforcement member 18 has a body 48, at least two first support parts 50 and at least two or more than two second support parts 52. Preferably, the at least two first support parts 50 and the at least two second support parts 52 extend from the body 48 and toward opposite directions. Wherein, the body 48 has a rear side 54 and a front side 56. Preferably, the at least two first support parts 50 extend from the body 48 and located on the rear side 54 of the body 48, and the at least two second support parts 52 extend from the body 48 and located on the front side 56 of the body 48. As shown in Fig. 3, the rear side 54 of the body 48 is located corresponding to the bridge wall 22 of the outer rail 10, and the front side 56 of the body 48 is located corresponding to the second side portion 38 of the second rear support 16b. The body 48 has a slot 58 and a contact portion 60 which extends from the body 48 and is inserted into the slot 58. Preferably, the contact portion 60 has a protrusion 62 which is configured to engage with the engaging hole 26 of the outer rail 10. The body 48 has a stop 64 which protrudes beyond the body 48. The stop 64 is located corresponding to the extension plate 44 of the second rear support 16b. Each of the at least two first support parts 50 comprises a first support plate 66a and a first bent section 66b. The first support plate 66a substantially extends perpendicularly from the body 48 of the reinforcement 18 and is located on the rear side 54 of the body 48. The first bent section 66b is bent from the first support plate 66a. Each of the at least two second support parts 52 of the reinforcement member 18 comprises a second support plate 68a and a second bent section 68b. The second support plate 68a substantially extends perpendicularly from the body 48 of the reinforcement 18 and is located on the front side 56 of the body 48. The second bent section 68b is bent from the second support plate 68a.

In practical use, as shown in Fig. 3, the reinforcement member 18 is mounted to the outer rail 10 by the at least two first support parts 50. When the protrusion 62 is moved to the engaging hole 26 of the outer rail 10, the reinforcement member 18 is engagedly positioned on the outer rail 10. Furthermore, the second rear support 16b is connected to the outer rail 10 by the at least two second support parts 52. As shown in Fig. 4, when the protrusion 62 of the contact portion 60 of the reinforcement member 18 is engaged with the engaging hole 26 of the outer rail 10 and positioned at the rear end of the outer rail 10, and when the second rear support 16b is extended to its extreme position relative to the first rear support 16a, the extension plate 44 of the second rear support 16b contacts the stop 64 of the reinforcement member 18 so as to stop the second rear support 16b. The at least two first support parts 50 is mounted to the outer rail 10, and the at least two second support parts 52 is mounted to the second support 16b. Preferably, the at least two first support parts 50 embrace the side walls 20 of the outer rail 10, and the at least two second support parts 52 movably embrace the two second support portions 36 of the second rear support 16b.

As shown in Fig. 4, the front support 14 and the second rear support 16b are respectively connected to the front post 72a and the rear post 72b of the rack 70. The length of the second rear support 16b relative to the first rear support 16a can be adjusted according the installation need so as to install the slide rail assembly to the front post 72a and the rear post 72b of the rack 70 by the use of the front support 14, the first rear support 16a and the second rear support 16b. Wherein, at a maximum extended position, the second rear support 16b is extended to its maximum distance relative to the first rear support 16a, the longitudinal length of the overlapped portions between the second rear support 16b and the first rear support 16a is reduced to the minimum, so that the support strength supported from the first rear support 16a to the second rear support 16b is reduced. Consequently, the support strength between the outer rail 10 and the second rear support 16b is reduced. The present invention uses the reinforcement member 18 to be mounted to the outer rail 10 and the second rear support 16b to reinforce the connection between the outer rail 10 and the second rear support 16b. Therefore, the slide rail assembly has sufficient support strength at the maximum extended position.

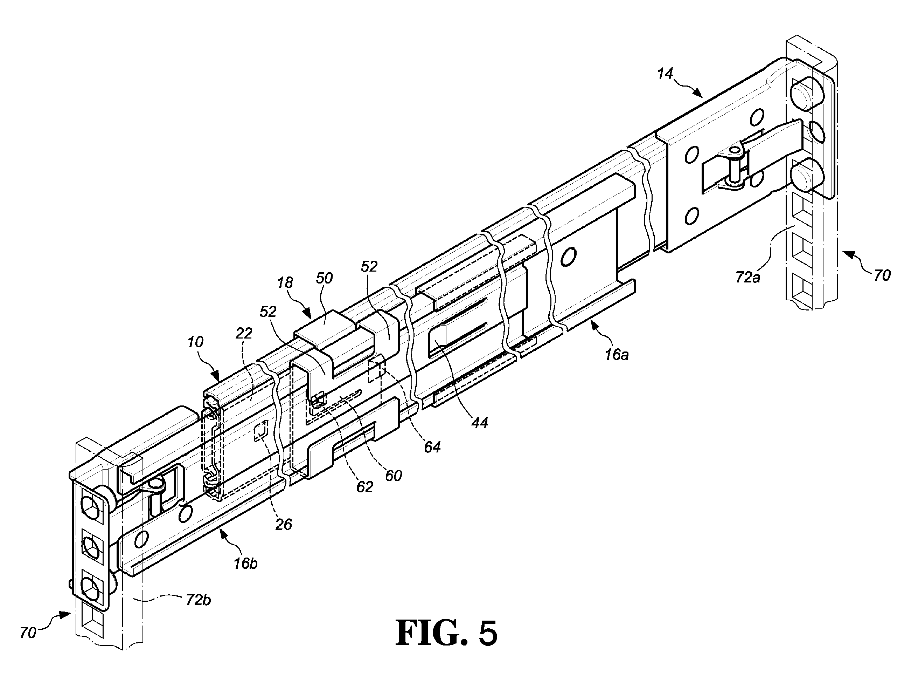

As shown in Fig. 5, when the second rear support 16b is retracted to a distance relative to the first rear support 16a, the extension plate 44 of the second rear support 16b is away from the stop 64 of the body 48 of the reinforcement member 18. The reinforcement member 18 is freely adjusted to remove the protrusion 62 from the engaging hole 26. By the contact between the contact portion 60 (such as the protrusion 62 on the contact portion 60) of the reinforcement member 18 and the bridge wall 22 of the outer rail 10, the reinforcement member 18 can be positioned. Preferably, the reinforcement member 18 is tight positioned by the contact between the contact portion 60 and the bridge wall 22.

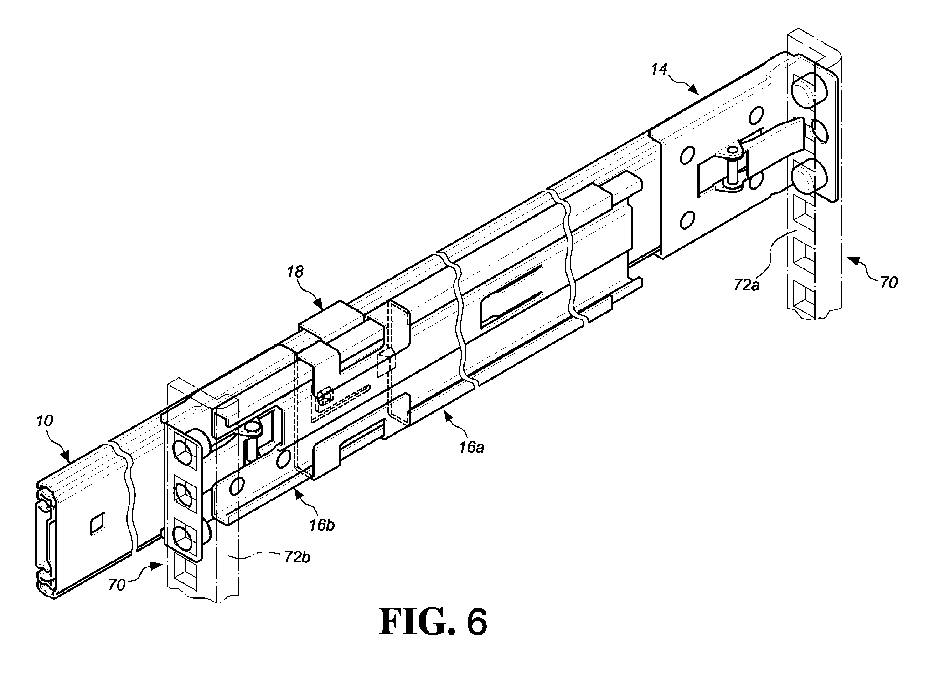

As shown in Fig. 6, when the second rear support 16b is completely retracted relative to the first rear support 16a, the reinforcement member 18 is pushed by the second rear support 16b to contact the first rear support 16a. Under the status, the total length of the slide rail assembly, involving the reinforcement member 18, can be retracted to the minimum.

Furthermore, the reinforcement member 18 can be detached from the second rear support 16b and the outer rail 10.

The present invention can be installed to different racks of different longitudinal depths, and the slide rail assembly has a strong and sufficient support strength by the reinforcement member 18.

While we have shown and described the embodiment in accordance with the present invention, it should be clear to those skilled in the art that further embodiments may be made without departing from the scope of the present invention as defined by the appended claims.

## Claims

1. A slide rail assembly, wherein the slide rail assembly comprises:
an outer rail (10) having a longitudinal length and two side walls (20) connected two sides of the outer rail (10), a bridge wall (22) connected between the two side walls (20), a longitudinal path (24) defined between the two side walls (20) and the bridge wall (22);
an inner rail (12) slidably connected to the longitudinal path (24) of the outer rail (10);
a front support (14) connected to a front end of the outer rail (10) and secured to the bridge wall (22);
a first rear support (16a) fixable installed to the bridge wall (22) of the outer rail (10) and having two first support portions (30) and a first side portion (32) being connected between the two first support portions (30), a first path (34) defined between the insides of the two first support portions (30) and the first side portion (32);
a second rear support (16b) movably located in the first path (34) of the first rear support (16a), the second rear support (16b) having two second support portions (36) and a second side portion (38) being connected between the two second support portions (36),
**characterized in that** it comprises a reinforcement member (18) having a body (48) having a rear side (54) and a front side (56);
at least two first support parts (50) extending from the body (48) and located on the rear side (54) of the body (48), and
at least two second support parts (52) extending from the body (48) and located on the front side (56) of the body (48), wherein the two first support parts (50) of the reinforcement member (18) are connected to the outer rail (10) and embracing the two side walls (20), and the at least two second support parts (52) of the reinforcement member (18) are connected to the second rear support (16b) and embracing the two second support portions (36).

2. The slide rail assembly as claimed in claim 1, wherein the body (48) has a slot (58), a contact portion (60) extends from the body (48) and is inserted into the slot (58).

3. The slide rail assembly as claimed in claim 1 or 2, wherein the body (48) has a stop (64) which protrudes beyond the body (48).

4. The slide rail assembly as claimed in claim 1, wherein an engaging hole (26) is defined in a rear end of the bridge wall (22) of the outer rail (10), the body (48) of the reinforcement member (18) has a slot (58) and a contact portion (60) which extends from the body (48) and is inserted into the slot (58), the contact portion (60) has a protrusion (62) which is engaged with the engaging hole (26) of the outer rail (10).

5. The slide rail assembly as claimed in claim 4, wherein the second side portion (38) of the second rear support (16b) has a side hole (42) and an extension plate (44) extends from the second side portion (38) and is inserted into the side hole (42), the body (48) of the reinforcement member (18) has a stop (64) which contacts the extension plate (44) of the second rear support (16b).

6. The slide rail assembly as claimed in any one of claims 4 or 5, wherein each of the first support parts (50) of the reinforcement member (18) comprises a first support plate (66a) and a first bent section (66b), the first support plate (66a) substantially extends perpendicularly from the body (48) of the reinforcement (18) and is located on a rear side (54) of the body (48), the first bent section (66b) is bent from the first support plate (66a).

7. The slide rail assembly as claimed in any one of claims 4-6, wherein each of the at least two second support parts (52) of the reinforcement member (18) comprises a second support plate (68a) and a second bent section (68b), the second support plate (68a) substantially extends perpendicularly from the body (48) of the reinforcement (18) and is located on a front side (56) of the body (48), the second bent section (68b) is bent from the second support plate (68a).

8. The slide rail assembly as claimed in claim 4, wherein the body (48) of the reinforcement member (18) has a slot (58), a contact portion (60) extends from the body (48) and is inserted into the slot (58).

9. The slide rail assembly as claimed in claim 4 or 8, wherein the body (48) of the reinforcement member (18) has a stop (64) which protrudes beyond the body (48).

10. A rack system, comprising a rack (70) and a slide rail assembly according to claim 8 and 9, the slide rail assembly further comprising an intermediate rail (28) slidably connected between the inner rail (12) and the outer rail (10), the rack (70) comprising a front post (72a) and a rear post (72b), the slide rail assembly secured to the rack (70) by connecting the front support (14) to the front post (72a) of the rack (70) and connecting the second rear support (16b) to the rear post (72b) of the rack (70), the reinforcement member (18) being freely adjustable, the contact portion (60) contacting the bridge wall (22) of the outer rail (10) to position the reinforcement member (18).

11. The rack system as claimed in claim 10, wherein an engaging hole (26) is defined in a rear end of the bridge wall (22) of the outer rail (10), the contact portion (60) has a protrusion (62) which is engaged with the engaging hole (26) of the outer rail (10).

12. The rack system as claimed in claim 10 or 11, wherein the second side portion (38) of the second rear support (16b) has a side hole (42) and an extension plate (44) extends from the second side portion (38) and inserted into the side hole (42), the stop (64) contacts the extension plate (44) of the second rear support (16b).

## Patentansprüche

1. Ein Aufbau einer Gleitschiene, wobei dieser Aufbau der Gleitschiene aus den folgenden Elementen besteht:
einer Außenschiene (10) mit einer Länge und zwei Seitenwänden (20), die an zwei Seiten der Außenschiene (10) befestigt ist; einer Brückenwand (22), die zwischen den beiden Seitenwänden (20) gebildet ist; einem Längsdurchlass (24), der zwischen den beiden Seitenwänden (20) und der Brückenwänden (22) gebildet ist;
einer Innenschiene (12), die gleitbar am Längsdurchlass (24) der Außenschiene (10) befestigt ist;
einem vorderen Träger (14), der an einem vorderen Ende der Außenschiene (10) befestigt und an der Brückenwand (22) gesichert ist;
einem ersten hinteren Träger (16a), der fest an der Brückenwand (22) der Außenschiene (10) befestigt ist und zwei erste Trägerteile (30) und ein erstes Seitenteil (32) aufweist, die zwischen den beiden ersten Trägerteilen (30) befestigt sind; einem ersten Durchlass (34), der zwischen den Innenseiten der beiden ersten Trägerteilen (30) und den ersten Seitenteilen (32) gebildet sind;
einem zweiten hinteren Träger (16b), der beweglich im ersten Durchlass (34) des ersten hinteren Trägers (16a) angeordnet ist; der zweite hintere Träger (16b) zwei zweite Trägerteile (36) aufweist und ein zweites Seitenteil (38) zwischen den beiden Trägerteilen (36) befestigt ist;
**dadurch gekennzeichnet, dass** dieses Ausführungsbeispiel aus einem Verstärkungsglied (18) besteht, das aus den folgenden Elementen besteht:
einem Körper (48) mit einer Rückseite (54) und einer Vorderseite (56);
mindestens zwei ersten Trägerteilen (50), die sich vom Körper (48) erstrecken und auf der Rückseite (54) des Körpers (48) angeordnet sind; und
mindestens zwei zweiten Trägerteilen (52), die sich vom Körper (48) erstrecken und auf der Vorderseite (56) des Körpers (48) angeordnet sind, wobei die beiden ersten Trägerteilen (50) des Verstärkungsgliedes (18) an der Außenschiene (10) befestigt sind, die beiden Seitenwänden (20) umgeben; die mindestens zwei zweiten Trägerteile (52) des Verstärkungsgliedes (18) am zweiten hinteren Träger (16b) befestigt sind und die beiden zweiten Trägerteile (36) umgeben.

2. Der Aufbau einer Gleitschiene nach Anspruch 1, wobei der Körper (48) eine Schlitzöffnung (58) aufweist, sich ein Kontaktelement (60) vom Körper (48) erstreckt und in die Schlitzöffnung (58) eingeführt ist.

3. Der Aufbau einer Gleitschiene nach Anspruch 1 oder 2, wobei der Körper (48) mit einem Anschlag (64) gebildet ist, der sich über den Körper (48) hinaus erstreckt.

4. Der Aufbau einer Gleitschiene nach Anspruch 1, wobei ein Einrastloch (26) in einem hinteren Ende der Brückenwand (22) der Außenschiene (10) gebildet ist; der Körper (10) des Verstärkungsgliedes (18) eine Schlitzöffnung (58) und ein Kontaktelement (60) aufweist, wobei sich letzteres vom Körper (48) erstreckt und in die Schlitzöffnung (58) eingeführt ist; das Kontaktelement (60) einen Vorsprung (62) aufweist, der in das Einrastloch (26) der Außenschiene (10) eingerastet ist.

5. Der Aufbau einer Gleitschiene nach Anspruch 4, wobei das zweite Seitenteil (38) des zweiten hinteren Trägers (16b) ein Seitenloch (42) aufweist, wobei sich vom zweiten Seitenteil (38) ein Verlängerungsplättchen (44) erstreckt und in das Seitenloch (42) eingeführt ist; der Körper (48) des Verstärkungsgliedes (18) einen Anschlag (64) aufweist, der mit dem Verlängerungsplättchen (44) des zweiten hinteren Trägers (16b) in Berührung kommt.

6. Der Aufbau einer Gleitschiene nach Anspruch 4 oder 5, wobei jedes der ersten Trägerteile (50) des Verstärkungsgliedes (18) ein erstes Trägerplättchen (66a) und einen ersten gebogenen Abschnitt (66b) aufweist; das erste Trägerplättchen (66a) sich im Wesentlichen senkrecht vom Körper (48) des Verstärkungsgliedes (18) erstreckt und nahe zu einer Rückseite (54) des Körpers (48) angeordnet ist; der erste gebogene Abschnitt (66b) vom ersten Trägerplättchen (66a) gebogen ist.

7. Der Aufbau einer Gleitschiene nach Anspruch 4-6, wobei jedes der mindestens zwei Trägerteile (52) des Verstärkungsgliedes (18) aus einem zweiten Trägerplättchen (68a) und aus einem zweiten gebogenen Abschnitt (68b) besteht; sich das zweite Trägerplättchen (68a) im Wesentlichen senkrecht vom Körper (48) des Verstärkungsgliedes (18) erstreckt und nahe zu einer Vorderseite (56) des Körpers (48) gebildet ist; der zweite gebogene Abschnitt (68b) vom zweiten Trägerplättchen (68a) gebogen ist.

8. Der Aufbau einer Gleitschiene nach Anspruch 4, wobei der Körper (48) des Verstärkungsgliedes (18) eine Schlitzöffnung (58) aufweist, sich ein Kontaktelement (60) vom Körper (48) erstreckt und in diese Schlitzöffnung (58) eingeführt ist.

9. Der Aufbau einer Gleitschiene nach Anspruch 4 oder 8, wobei der Körper (48) des Verstärkungsgliedes (18) einen Anschlag (64) aufweist, der sich über den Körper (48) hinaus erstreckt.

10. Einer Montage eines Gestells, umfassend einem Gestell (70) und einem Aufbau einer Gleitschiene nach Anspruch 8 und 9, wobei der Aufbau der Gleitschiene weiter aus einer Mittenschiene (28) besteht und diese Mittenschiene (28) gleitbar zwischen der Innenschiene (12) und der Außenschiene (10) befestigt ist; das Gestell (70) eine vordere Stütze (72a) und eine hintere Stütze (72b) umfaßt; der Aufbau der Gleitschiene durch Befestigen des vorderen Trägers (14) an der vorderen Stütze (72a) des Gestells (70) und durch Befestigen des zweiten hinteren Trägers (16b) an der hinteren Stütze (72b) des Gestells (70) am Gestell (70) gesichert ist; das Verstärkungsglied (18) frei justierbar ist; das Kontaktelement (60) mit der Brückenwand (22) der Außenschiene (10) in Berührung kommt, um das Verstärkungsglied (18) zu positionieren.

11. Die Montage eines Gestells nach Anspruch 10, wobei in einem hinteren Ende der Brückenwand (22) der Außenschiene (10) ein Einrastloch (26) gebildet ist; das Kontaktelement (60) einen Vorsprung (62) aufweist, der in das Einrastloch (26) der Außenschiene (10) eingerastet ist.

12. Die Montage eines Gestells nach Anspruch 10 oder 11, wobei das zweite Seitenteil (38) des zweiten hinteren Trägers (16b) ein Seitenloch (42) aufweist, während sich ein Verlängerungsplättchen (44) vom zweiten Seitenteil (38) erstreckt und in das Seitenloch (42) eingeführt ist; der Anschlag (64) mit dem Verlängerungsplättchen (44) des zweiten hinteren Trägers (16b) in Berührung kommt.

## Revendications

1. Un assemblage de rails coulissant, dans lequel l'assemblage de rails coulissant comprend :
un rail extérieur (10) ayant une longueur longitudinale et deux parois latérales (20) reliées à deux côtés du rail extérieur (10), une paroi de pont (22) connectée entre les deux parois latérales (20), une trajectoire longitudinale (24) définie entre les deux parois latérales (20) et la paroi de pont (22) ;
un rail intérieur (12) relié de manière coulissante à la trajectoire longitudinale (24) du rail extérieur (10) ;
un support avant (14) relié à l'extrémité avant du rail extérieur (10) et attaché à la paroi de pont (22) ;
un premier support arrière (16a) installé de manière fixe sur la paroi de pont (22) du rail extérieur (10) et ayant deux premières parties de support (30) et une première partie latérale (32) étant reliée entre les deux premières parties de support (30), une première trajectoire (34) définie entre les intérieurs des deux premières parties de support (30) et la première partie latérale (32) ;
un second support arrière (16b) situé de manière mobile dans la première trajectoire (34) du premier support arrière (16a), le second support arrière (16b) ayant deux secondes parties de support (36) et une seconde partie latérale (38) étant connectée entre les deux secondes parties de support (36),
**caractérisé en ce qu'**il comprend un élément de renforcement (18) ayant un corps (48) ayant un côté arrière (54) et un côté avant (56) ;
au moins deux pièces du premier support (50) en extension à partir du corps (48) et situées sur le côté arrière (54) du corps (48), et
au moins deux pièces du second support (52) en extension à partir du corps (48) et situées sur le côté avant (56) du corps (48), dans lequel les deux pièces du premier support (50) de l'élément de renforcement (18) sont reliées au rail extérieur (10) et incluant les deux parois latérales (20), et les deux pièces au minimum du second support (52) de l'élément de renforcement (18) sont reliées au second support arrière (16b) et incluant les deux secondes parties de support (36).

2. L'assemblage de rails coulissant selon la revendication 1, dans lequel le corps (48) a une rainure (58), une partie de contact (60) s'étend à partir du corps (48) et est insérée dans la rainure (58).

3. L'assemblage de rails coulissant selon la revendication 1 ou 2, dans lequel le corps (48) a une butée (64) en saillie au-delà du corps (48).

4. L'assemblage de rails coulissant selon la revendication 1, dans lequel un trou de prise (26) est défini dans une extrémité arrière de la paroi de pont (22) du rail extérieur (10), le corps (48) de l'élément de renforcement (18) a une rainure (58) et une partie de contact (60) qui s'étend à partir du corps (48) et est insérée dans la rainure (58), la partie de contact (60) a une protubérance (62) qui est engagée avec le trou de prise (26) du rail extérieur (10).

5. L'assemblage de rails coulissant selon la revendication 4, dans lequel la seconde partie latérale (38) du second support arrière (16b) a un trou latéral (42) et une plaque d'extension (44) s'étend à partir de la seconde partie latérale (38) et est insérée dans le trou latéral (42), le corps (48) de l'élément de renforcement (18) a une butée (64) qui est en contact avec la plaque d'extension (44) du second support arrière (16b).

6. L'assemblage de rails coulissant selon l'une des revendications 4 ou 5, dans lequel chacune des pièces du premier support (50) de l'élément de renforcement (18) comprend une première plaque de support (66a) et une première section courbée (66b), la première plaque de support (66a) s'étend perpendiculairement de manière substantielle à partir du corps (48) du renforcement (18) et est située sur un côté arrière (54) du corps (48), la première section courbée (66b) est courbée à partir de la première plaque de support (66a).

7. L'assemblage de rails coulissant selon l'une des revendications 4-6, dans lequel chacune des deux pièces au minimum du second support (52) de l'élément de renforcement (18) comprend une seconde plaque de support (68a) et une seconde section courbée (68b), la seconde plaque de support (68a) s'étend perpendiculairement de manière substantielle à partir du corps (48) du renforcement (18) et est située sur un côté avant (56) du corps (48), la seconde section courbée (68b) est courbée à partir de la seconde plaque de support (68a).

8. L'assemblage de rails coulissant selon la revendication 4, dans lequel le corps (48) de l'élément de renforcement (18) a une rainure (58), une partie de contact (60) s'étend à partir du corps (48) et est insérée dans la rainure (58).

9. L'assemblage de rails coulissant selon les revendications 4 ou 8, dans lequel le corps (48) de l'élément de renforcement (18) a une butée (64) en saillie au-delà du corps (48).

10. Un système de rack, comprenant un rack (70) et un assemblage de rails coulissant d'après les revendications 8 et 9, l'assemblage de rails coulissant comprenant en outre un rail intermédiaire (28) relié de manière coulissante entre le rail intérieur (12) et le rail extérieur (10), le rack (70) comprenant un montant avant (72a) et un montant arrière (72b), l'assemblage de rails coulissant fixé au rack (70) en reliant le support avant (14) au montant avant (72a) du rack (70) et en reliant le second support arrière (16b) au montant arrière (72b) du rack (70), l'élément de renforcement (18) étant librement réglable, la partie de contact (60) étant en contact avec la paroi de pont (22) du rail extérieur (10) pour positionner l'élément de renforcement (18).

11. Le système de rack selon la revendication 10, dans lequel un trou de prise (26) est défini dans une extrémité arrière de la paroi de pont (22) du rail extérieur (10), la partie de contact (60) a une protubérance (62) qui est engagée avec le trou de prise (26) du rail extérieur (10).

12. Le système de rack selon les revendications 10 ou 11, dans lequel la seconde partie latérale (38) du second support arrière (16b) a un trou latéral (42) et une plaque d'extension (44) s'étend à partir de la seconde partie latérale (38) et insérée dans le trou latéral (42), la butée (64) est en contact avec la plaque d'extension (44) du second support arrière (16b).
